# EUROPEAN PATENT APPLICATION

(11) **EP 4 564 442 A1**
(43) Date of publication of application: **04.06.2025**
(21) Application number: 23918116.7
(22) Date of filing: 29.01.2023
(51) Int. Cl.: H01L 33/58, H10K 50/844

(54) **DISPLAY SUBSTRATE, TILED DISPLAY MODULE AND DISPLAY DEVICE**

(71) Applicant: Boe Technology Group Co., Ltd., Beijing 100015 (CN); BOE MLED Technology Co., Ltd., Beijing 100176 (CN)
(72) Inventor: YANG, Zezhou, Beijing 100176 (CN); JIN, Liangliang, Beijing 100176 (CN); ZHAO, Le, Beijing 100176 (CN); ZHANG, Qingkai, Beijing 100176 (CN); CHEN, Chenchang, Beijing 100176 (CN); MA, Ruoyu, Beijing 100176 (CN); LI, Jiao, Beijing 100176 (CN); SUN, Wenjia, Beijing 100176 (CN); LI, Jinpeng, Beijing 100176 (CN); ZHAI, Ming, Beijing 100176 (CN); SUN, Haiwei, Beijing 100176 (CN)
(74) Representative: Durán-Corretjer, S.L.P.
(86) International application number: PCT/CN2023/073671
(87) International publication number: WO 2024/156110

(57) **Abstract**

The present application provides a display substrate, a tiled display module and a display device. The display substrate comprises a substrate, a light-emitting unit group located on the substrate, a first light adjusting layer located on the substrate, and a second light adjusting layer located on the side of the first light adjusting layer away from the substrate. The light-emitting unit group comprises a plurality of light-emitting units. The distance from the surface of the first light adjusting layer away from the substrate to the substrate is greater than the distance from the surfaces of the light-emitting units away from the substrate to the substrate. The orthographic projection of the second light adjusting layer on the substrate covers the substrate; and the light transmittance of the first light adjusting layer is greater than the light transmittance of the second light adjusting layer. The tiled display module includes a plurality of tiled units, and the tiled units comprising the display substrate. The display apparatus comprises the display substrate or the tiled display module.

## Description

### TECHNICAL FIELD

The present disclosure relates to display technology, and in particular, to a display substrate, a spliced display module and a display apparatus

### BACKGROUND

A Mini Light-emitting Diode (Mini LED) is about 100-300 µm in size. A Micro Light Emitting Diode (Micro LED) is 100 µm or less in size. Since the Mini LED and the Micro LED have a good display effect, and at the same time have the advantages of high contrast and long life, therefore their usage trend in the display field is obvious.

### SUMMARY

The present disclosure provides a display substrate, a spliced display module and a display apparatus.

The first aspect of embodiments of the present disclosure provides a display substrate, the display substrate includes:
a substrate;
a light-emitting unit group on the substrate including a plurality of light-emitting units;
a first light adjustment layer on the substrate; where a distance from a surface of the first light adjustment layer away from the substrate to the substrate is greater than a distance from a surface of one of the plurality of light-emitting units away from the substrate to the substrate; and
a second light adjustment layer on the first light adjustment layer and away from the substrate, where an orthographic projection of the second light adjustment layer on the substrate covers the substrate; and a transmittance of the first light adjustment layer is greater than a transmittance of the second light adjustment layer.

In an embodiment, the first light adjustment layer includes a first sub-layer, and an orthographic projection of the first sub-layer on the substrate covers respective orthographic projections of each of the light-emitting units on the substrate; where the first sub-layer includes a light-transmitting material and scattering particles dispersed in the light-transmitting material.

In an embodiment, the scattering particles include first particles and second particles, and a transmittance of the first particles is greater than a transmittance of the second particles.

In an embodiment, a mass percentage range of the first particles in the first sub-layer is from 10 % to 20 %, and a mass percentage range of the second particles in the first sub-layer is from 1 % to 5 *%;*
and/or, a transmittance range of the first sub-layer is from 45 % to 70 %.

In an embodiment, a material of the first particles includes silicon dioxide, polymethylmethacrylate, polystyrene, or any combination thereof, and a material of the second particles includes titanium dioxide, zinc oxide, or both; where a particle size range of the first particles is from 400nm to 600nm, and a particle size range of the second particles is from 4 µm to 6 µm.

In an embodiment, the first light adjustment layer further includes a second sub-layer on the first sub-layer and away from the substrate, where the first sub-layer covers each of the plurality of light-emitting units; and a hardness of the second sub-layer is greater than a hardness of the first sub-layer.

In an embodiment, the first light adjustment layer further includes a second sub-layer on a side of the first sub-layer towards the substrate, and a hardness of the first sub-layer is greater than a hardness of the second sub-layer.

In an embodiment, a transmittance of the first sub-layer is less than a transmittance of the second sub-layer.

In an embodiment, a surface of the first sub-layer towards the substrate is in direct contact with the light-emitting unit, and a surface of the first sub-layer away from the substrate is in direct contact with the second light adjustment layer.

In an embodiment, an adhesion force between the second light adjustment layer and the first light adjustment layer is F1, an adhesion force between the first light adjustment layer and the light-emitting unit is F2, and F1>F2.

In an embodiment, the first light adjustment layer includes a first sub-layer and a second sub-layer on the first sub-layer and away from the substrate; an adhesion force between the second light adjustment layer and the second sub-layer is F3, an adhesion force between the second sub-layer and the first sub-layer is F4, an adhesion force between the first sub-layer and the light-emitting unit is F5, F3≥F4>F5; or,
the first light adjustment layer includes a first sub-layer and a second sub-layer on a side of the first sub-layer towards the substrate; an adhesion force between the second light adjustment layer and the first sub-layer is F6, an adhesion force between the sub-layer and the second sub-layer is F7, an adhesion force between the second sub-layer and the light-emitting unit is F8, and F6≥F7>F8.

In an embodiment, a thickness range of the second light adjustment layer is from 25 µm to 50 µm; and/or, a transmittance range of the second light adjustment layer is from 25 % to 40 %.

In an embodiment, the display substrate further includes a protective layer on the second light adjustment layer and away from the substrate.

In an embodiment, an adhesion force between the protective layer and the second light adjustment layer is F9, an adhesion force between the second light adjustment layer and the first light adjustment layer is F1, and F9≥F1.

In an embodiment, the display substrate further includes a functional film layer on the protective layer and away from the substrate, and the functional film layer includes a hardened coating, an anti-fingerprint layer, an anti-glare layer, or any combination thereof.

The second aspect of embodiments of the present disclosure provides a spliced display module, where the spliced display module includes a plurality of splicing units, and each of the plurality of splicing units includes the display substrate described above.

The third aspect of embodiments of the present disclosure a display apparatus, the display apparatus includes the display substrate described above, or, the display apparatus includes the spliced display module described above.

According to the display substrate, the spliced display module and the display apparatus provided by embodiments of the present disclosure, the second light adjustment layer is located on one side of the first light adjustment layer away from the substrate, the transmittance of the second light adjustment layer is smaller than the transmittance of the first light adjustment layer, then the second light adjustment layer can increase the blackness of the display substrate in the non-display state, which helps improve user experience; since the distance from the surface of the first light adjustment layer away from the substrate to the substrate is greater than the distance from the surface of the light-emitting unit away from the substrate to the substrate, it can be avoided that the light-emitting unit squeezes the second light adjustment layer to cause uneven thickness of the second light adjustment layer, which improves the uniformity of the thickness of the second light adjustment layer, helps improve the consistency of brightness at a large viewing angle in all parts of the display substrate, and further improves user experience.

### BRIEF DESCRIPTION OF DRAWINGS

FIG. 1 is a partial cross-sectional view of a display substrate according to an exemplary embodiment of the present disclosure;
FIG. 2 is a relationship curve of correspondence between brightness at a large viewing angle and position of a display substrate as a comparison;
FIG. 3 is a relationship curve of correspondence between brightness at a large viewing angle and position of a display substrate according to an exemplary embodiment of the present disclosure;
FIG. 4 is a partial cross-sectional view of a display substrate according to another exemplary embodiment of the present disclosure;
FIG. 5 is a partial cross-sectional view of a display substrate according to another exemplary embodiment of the present disclosure;
FIG. 6 is a partial cross-sectional view of a display substrate according to another exemplary embodiment of the present disclosure;
FIG. 7 is relationship curves of correspondence between color deviation value and viewing angle of a display substrate when three display substrates include different first sub-layers;
FIG. 8 is a partial cross-sectional view of a display substrate according to another exemplary embodiment of the present disclosure;
FIG. 9 is a partial cross-sectional view of a display substrate according to another exemplary embodiment of the present disclosure;
FIG. 10 is a partial cross-sectional view of a spliced display module according to an exemplary embodiment of the present disclosure;
FIG. 11 is a partial cross-sectional view of a spliced display module according to another exemplary embodiment of the present disclosure.

### DETAILED DESCRIPTION

Exemplary embodiments will be described in detail here, examples of which are illustrated in the accompanying drawings. When the following description relates to the accompanying drawings, unless specified otherwise, the same numerals in different drawings represent the same or similar elements. The implementations described in the following exemplary embodiments do not represent all implementations consistent with the present disclosure. Conversely, they are merely examples of apparatuses and methods consistent with some aspects of the present disclosure as detailed in the appended claims.

The terms used in this application are merely for the purpose of describing specific embodiments, and are not intended to limit this application. The terms "a", "said" and "the" of singular forms used in this application and the appended claims are also intended to include plural forms, unless the context clearly indicates otherwise. It should also be understood that, the term "and/or" used herein indicates and includes any or all possible combinations of one or more associated listed items.

It should be understood that although the terms such as first, second, and third may be used herein to describe various information, such information should not be limited to these terms. These terms are only used to distinguish information of the same category with each other. For example, without departing from the scope of the present disclosure, first information may be referred as second information; and similarly, second information may also be referred as first information. Depending on the context, the word "if" as used herein may be interpreted as "when" or "upon" or "in response to determining".

Embodiments of the present disclosure provide a display substrate, a spliced display module and a display apparatus. The display substrate, the spliced display module and the display apparatus in embodiments of present disclosure are described in detail below with reference to the accompanying drawings. If there is no conflict, features in the embodiments described below may complement each other or be combined with each other.

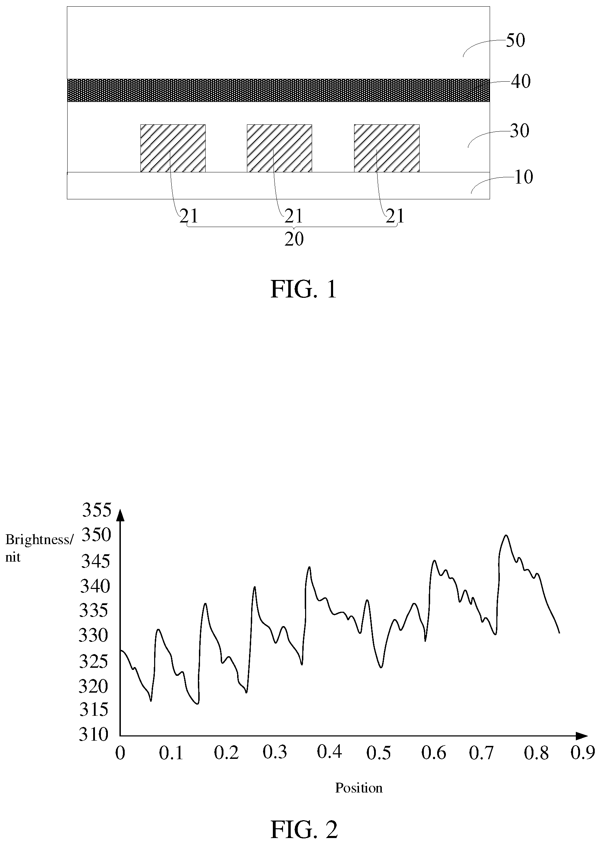

Embodiments of the present disclosure provide a display substrate. As illustrated in FIG. 1, the display substrate includes a substrate 10, a light-emitting unit group 20 located on the substrate 10, a first light adjustment layer 30 located on the substrate 10, and a second light adjustment layer 40 located on the first light adjustment layer 30 and away from the substrate 10. The first light adjustment layer 30 and the light-emitting unit group 20 are located on the same side of the substrate 10.

The light-emitting unit group 20 includes a plurality of light-emitting units 21. The distance from the surface of the first light adjustment layer 30 away from the substrate 10 to the substrate 10 is greater than the distance from the surface of the light-emitting unit 21 away from the substrate 10 to the substrate 10. The orthographic projection of the second light adjustment layer 40 on the substrate 10 covers the substrate 10; and the transmittance of the first light adjustment layer 30 is greater than the transmittance of the second light adjustment layer 40.

According to the display substrate provided by the embodiments of the present disclosure, the second light adjustment layer 40 is located on one side of the first light adjustment layer 30 away from the substrate 10, the transmittance of the second light adjustment layer 40 is smaller than the transmittance of the first light adjustment layer 30, then the second light adjustment layer 40 can increase the blackness of the display substrate in the non-display state, which helps improve user experience; since the distance from the surface of the first light adjustment layer 30 away from the substrate 10 to the substrate 10 is greater than the distance from the surface of the light-emitting unit 21 away from the substrate 10 to the substrate 10, it can be avoided that the light-emitting unit 21 squeezes the second light adjustment layer 40 and causes uneven thickness of the second light adjustment layer 40, which improves the uniformity of the thickness of the second light adjustment layer 40, helps improve the consistency of brightness at a large viewing angle in all parts of the display substrate, and further improves user experience.

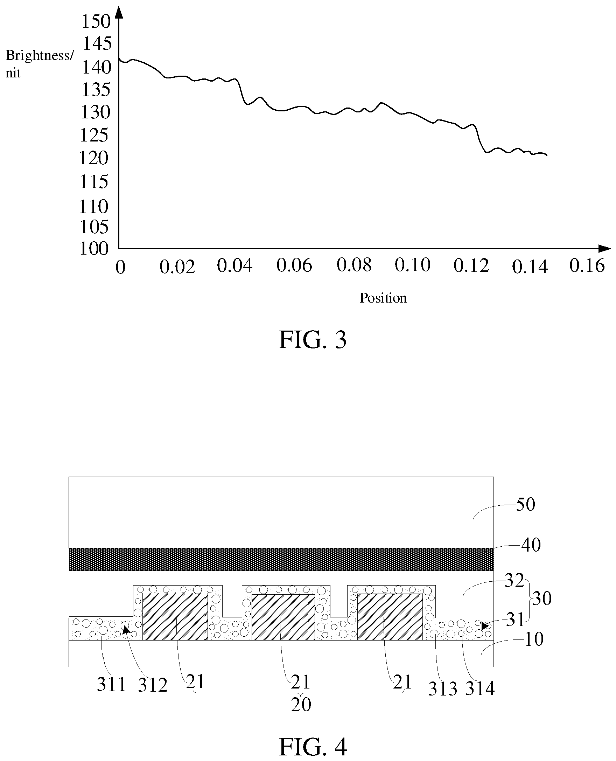

FIG. 2 is a relationship curve of correspondence between brightness and position of a display substrate at a large viewing angle as a comparison, and FIG. 3 is a relationship curve of correspondence between brightness and position of a display substrate at a large viewing angle provided by an embodiment of the present disclosure. The difference between the display substrate as a comparison and the display substrate provided by the embodiment of the present disclosure is that, the first light adjustment layer is located on a side of the second light adjustment layer away from the substrate, and the second light adjustment layer is in contact with the light-emitting unit. The display substrate as a comparison and the display substrate provided by the embodiment of the present disclosure both include the first end and the second end opposite to each other. In FIG. 2 and FIG. 3, the abscissa is the ratio of the distance between different positions and the first end to the distance between the first end and the second end, the ordinate is the brightness. It can be seen from FIG. 2 and FIG. 3 that, the brightness of the display substrate at a large viewing angle as a comparison changes regularly, while the brightness of the display substrate at a large viewing angle provided by the embodiment of the present disclosure changes irregularly, and the brightness consistency of the display substrate at different positions at a large viewing angle is better.

In an embodiment, the display substrate further includes a protective layer 50 located on a side of the second light adjustment layer 40 away from the substrate 10. The protective layer 50 can protect the second light adjustment layer 40.

In an embodiment, the transmittance of the protective layer 50 is greater than the transmittance of the first light adjustment layer 30, and the light emitted by the light-emitting unit 21 loses less when passing through the protective layer 50.

In an embodiment, the material of the protective layer 50 includes polyethylene terephthalate (PET), polycarbonate (PC), etc. In this manner, the transmittance of the protective layer 50 can be higher, and the hardness of the protective layer 50 can be larger, which improves the anti-pressure capability and anti-collision capability of the display substrate and has better protection effect for the underlying film layer and light-emitting elements.

In an embodiment, the preparation process of the display substrate can include as follows: first, fixing the light-emitting unit 21 on the substrate 10, to obtain the first intermediate structure; afterwards, forming the second light adjustment layer 40 on the protective layer 50 and the first light adjustment layer 30 located on a side of the second light adjustment layer 40 away from the protective layer 50, to obtain the second intermediate structure; afterwards, performing vacuum lamination on the first intermediate structure and the second intermediate structure, and the first light adjustment layer 30 is in contact with the light-emitting unit 21, then the display substrate can be obtained.

In an embodiment, the substrate 10 may be a flexible substrate or a rigid substrate. The material of the flexible substrate may include one or more of polyimide, polyethylene terephthalate, polycarbonate, and organic resin materials, the organic resin materials may include epoxy resin, triazine, silicone resin or polyimide, etc. A rigid substrate includes any one of a glass substrate, a quartz substrate, a sapphire substrate, a ceramic substrate, etc.; or any one of semiconductor substrates such as a single crystal semiconductor substrate or a polycrystalline semiconductor substrate made of silicon or silicon carbide, etc., a semiconductor substrate of silicon, germanium, etc., a silicon-on-insulator (SOI) substrate, etc. In some example embodiments, the substrate may include any one of a ceramic material such as silicon nitride, AlN, or Al2O3, a metal or metal compound, a metal core printed circuit board (MCPCB), or a metal copper clad laminate (MCCL). In some embodiments, the substrate 10 may include a substrate base and a drive circuit layer formed on the substrate base, the drive circuit layer includes a pixel circuit used for driving light-emitting elements and an insulation film layer, the light-emitting element and the pixel circuit are electrically connected.

In an embodiment, the light-emitting unit group 20 includes light-emitting units 21 with three emission colors, which are separately: a light-emitting unit 21 with the red emission color, a light-emitting unit 21 with the green emission color, and a light-emitting unit 21 with the blue emission color.

In an embodiment, the light-emitting unit 21 may be a Mini LED or a Micro LED, the size of Mini LED is approximately 100 µm to 500 µm, the size of Micro LED is less than 100 µm.

In an embodiment, the orthographic projection of the first light adjustment layer 30 on the substrate 10 covers the substrate 10. That is, the first light adjustment layer 30 covers the light-emitting units 21 and the gaps between adjacent light-emitting units 21. This is more conducive to avoiding that the light-emitting unit 21 squeezes the second light adjustment layer 40, further improving the uniformity of the thickness of the second light adjustment layer 40, which can more effectively improve the consistency of brightness at a large viewing angle in all parts of the display substrate; and almost all of the light emitted by the light-emitting unit 21 passes through the first light adjustment layer 30 during the emission process, which also helps improve the uniformity of the brightness of the display substrate.

In an embodiment, the surface of the first light adjustment layer 30 away from the substrate 10 is flush everywhere. This helps improve the thickness uniformity of the second light adjustment layer 40.

In an embodiment, the adhesion force between the second light adjustment layer 40 and the first light adjustment layer 30 is F1, the adhesion force between the first light adjustment layer 30 and the light-emitting unit 21 is F2, and F1>F2. When the light-emitting unit 21 needs to be reworked, the first light adjustment layer 30 and the second light adjustment layer 40 need to be peeled off from the light-emitting unit 21. Since F1>F2, during the process of peeling off the first light adjustment layer 30 and the second light adjustment layer 40 from the light-emitting unit 21, it can ensure that, when the first light adjustment layer 30 is separated from the light-emitting unit 21, the first light adjustment layer 30 and the second light adjustment layer 40 are not separated, avoiding the situation that the first light adjustment layer 30 and the second light adjustment layer 40 are separated while the first light adjustment layer 30 and the light-emitting unit 21 are still adhered together. The first light adjustment layer 30 and the second light adjustment layer 40 together can be smoothly peeled off from the light-emitting unit 21, which helps realize the rework of the light-emitting unit 21.

Further, the adhesion force between the protective layer 50 and the second light adjustment layer 40 is F9, F9≥F1. With this arrangement, when the light-emitting unit 21 needs to be reworked, during the process of peeling off the protective layer 50, the first light adjustment layer 30, and the second light adjustment layer 40 from the light-emitting unit 21, it can ensure that, the protective layer 50 and the second light adjustment layer 40 are not separated, so that the protective layer 50, the first light adjustment layer 30, and the second light adjustment layer 40 together are smoothly peeled off from the light-emitting unit 21.

In an embodiment, as illustrated in FIG. 4 to FIG. 6, the first light adjustment layer 30 includes the first sub-layer 31, the orthographic projection of the first sub-layer 31 on the substrate 10 covers the respective orthographic projections of the light-emitting units 21 on the substrate 10; the first sub-layer 31 includes a light-transmitting material 311 and scattering particles 312 dispersed in the light-transmitting material 311. By arranging that the orthographic projection of the first sub-layer 31 on the substrate 10 covers the respective orthographic projections of the light-emitting units 21 on the substrate 10, the light emitted by the light-emitting unit 21 passes through the first sub-layer 31 during the emission process, and the first sub-layer 31 can enhance the scattering degree of the light emitted by the light-emitting unit 21, thereby increasing the viewing angle of the display substrate, and the light color differences can be reduced between the frontal viewing angle and a large viewing angle, thereby improving user experience.

In an embodiment, the orthographic projection of the first sub-layer 31 on the substrate 10 covers the substrate 10. With this arrangement, almost all of the light emitted by the light-emitting unit 21 passes through the first sub-layer 31 during the emission process in the direction away from the substrate 10, which is more conducive to increasing the vision of the display substrate and reducing the light color differences between the frontal viewing angle and a large viewing angle.

In an embodiment, as illustrated in FIG. 4 to FIG. 6, the scattering particles 312 include the first particles 313 and the second particles 314, and the transmittance of the first particle 313 is greater than the transmittance of the second particle 314. By arranging that the scattering particles include the first particles 313 and the second particles 314 with different transmittances, compared to the case where all the scattering particles 312 are the second particles 314, the transmittance of the first sub-layer 31 can be increased, thereby reducing the light loss during the emission process of the light-emitting unit 21; compared to the case where all the scattering particles 312 are the first particles 313, the light color differences between the frontal viewing angle and a large viewing angle can be reduced, thereby improving user experience.

In an embodiment, the second particles 314 are white particles. The material of the second particles includes at least one of titanium dioxide and zinc oxide.

In an embodiment, the material of the first particles 313 includes at least one of silicon dioxide, polymethyl methacrylate (PMMA), and polystyrene (PS).

In an embodiment, the mass percentage range of the first particles in the first sub-layer is 10 % to 20 %, and the mass percentage range of the second particles in the first sub-layer is 1 % to 5 %. This arrangement can, on the premise of ensuring that the transmittance of the first sub-layer 31 is relatively high, effectively reduce the color differences between a large viewing angle and the frontal viewing angle. In some embodiments, the mass percentage of the first particles 313 in the first sub-layer 31 may be 10 %, 12 %, 14 %, 16 %, 17 %, 20 %, etc.; and the mass percentage of the second particles 314 in the first sub-layer 31 may be 1 %, 2 %, 3 %, 4 %, 5 %, etc.

In an embodiment, the particle size range of the first particles is 4 µm to 6 µm, the particle size range of the second particles is 400nm to 600nm. In some embodiments, the particle size range of the second particles may be 400nm, 450nm, 500nm, 550nm, 600nm, etc., the average particle size range of the second particles may be approximately 500nm; the particle size range of the second particles may be 4 µm, 4.5 µm, 5 µm, 5.5 µm, 6 µm, etc., the average particle size range of the second particles may be approximately 5 µm.

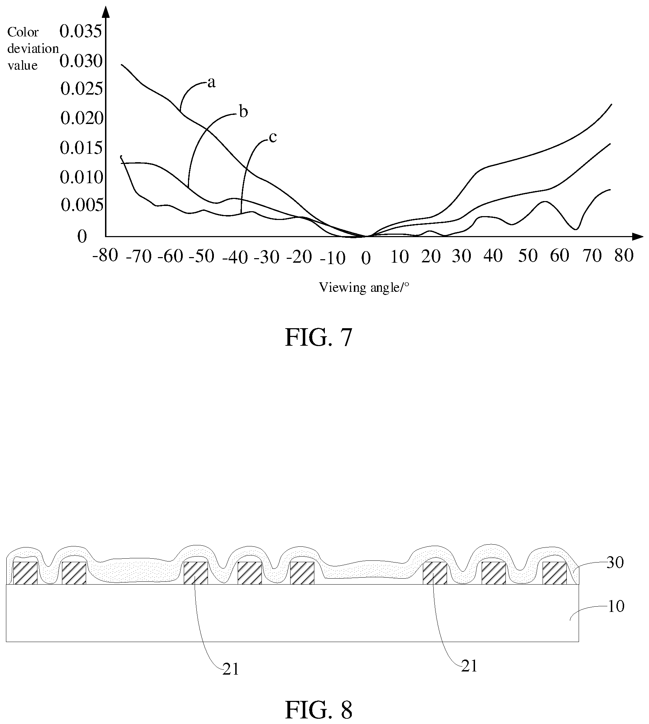

FIG. 7 is relationship curves of correspondence between color deviation value Δu'v' and viewing angle of a display substrate when three display substrates include different first sub-layers, where, curve *a* is the relationship curve of correspondence between color deviation value and viewing angle of the display substrate when all the scattering particles in the first sub-layer are the first particles, curve b is the relationship curve of correspondence between color deviation value and viewing angle of the display substrate when the scattering particles in the first sub-layer include the first particles and the second particles, curve c is the relationship curve of correspondence between color deviation value and viewing angle of the display substrate when all the scattering particles in the first sub-layer are the second particles, and the thickness of the first sub-layer is 50 µm.It can be seen from FIG. 7 that, when all the scattering particles in the first sub-layer are the first particles, the color deviation value at a large viewing angle of the display substrate is 0.029; when all the scattering particles in the first sub-layer are the second particles, the color deviation value at a large viewing angle of the display substrate is 0.014; when the scattering particles in the first sub-layer include the first particles and the second particles, the color deviation value at a large viewing angle of the display substrate is 0.016. That is, when all the scattering particles in the first sub-layer are the first particles, the color deviation value at a large viewing angle of the display substrate is the largest; when all the scattering particles in the first sub-layer are the second particles, the color deviation value at a large viewing angle of the display substrate is the smallest; when the scattering particles in the first sub-layer include the first particles and the second particles, the color deviation value at a large viewing angle of the display substrate is in the middle.

In the embodiments of the present disclosure, simulation tests were conducted on the above three different display substrates, in which the thickness of the first sub-layers in the three display substrates was all 50 µm.The three display substrates differ in the scattering particles in the first sub-layer. After simulation tests, the following results were obtained: when all the scattering particles in the first sub-layer are the first particles, the transmittance of the display substrate is 135 %; when all the scattering particles in the first sub-layer are the second particles, the transmittance of the display substrate is 100 %; when the scattering particles in the first sub-layer include the first particles and the second particles, the transmittance of the display substrate is 118 %. That is, when all the scattering particles in the first sub-layer are the first particles, the transmittance of the display substrate is the largest; when all the scattering particles in the first sub-layer are the second particles, the transmittance of the display substrate is the smallest; when the scattering particles in the first sub-layer include the first particles and the second particles, the transmittance of the display substrate is in the middle.

Combining FIG. 7 and the results of simulation test, considering the transmittance and the color deviation value at a large viewing angle of the display substrate, it is preferred that the scattering particles in the first sub-layer of the display substrate include the first particles and the second particles.

In an embodiment, the transmittance range of the first sub-layer is 45 % to 70 %. In some embodiments, the transmittance of the first sub-layer is 45 %, 50 %, 55 %, 60 %, 65 %, 70 %, etc.

In an embodiment, as illustrated in FIG. 4, the first light adjustment layer 30 further includes the second sub-layer located 32 on a side of the first sub-layer 31 away from the substrate 10, and the first sub-layer 31 covers each of the light-emitting units 21; the hardness of the second sub-layer 32 is greater than the hardness of the first sub-layer 31. Since the second sub-layer 32 is in contact with the second light adjustment layer 40 and the first sub-layer 31 is in contact with the light-emitting unit 21, by arranging that the hardness of the second sub-layer 32 is greater than the hardness of the first sub-layer 31, then the second sub-layer 32 can more effectively prevent the light-emitting unit 21 from squeezing the second light adjustment layer 40 and improve the thickness uniformity of the second light adjustment layer 40; when the light-emitting unit 21 needs to be reworked, the film layer located on a side of the light-emitting unit 21 away from the substrate 10 needs to be separated from the light-emitting unit 21, since the hardness of the first sub-layer 31 is smaller, the first sub-layer 31 is softer and easier to be separated from the light-emitting unit 21, which facilitates the rework of the light-emitting unit 21.

In this embodiment, the transmittance of the first sub-layer 31 is less than the transmittance of the second sub-layer 32. This arrangement can, on the premise of ensuring that the first light adjustment layer 30 and the light-emitting unit 21 are easily separated, improve the transmittance of the first light adjustment layer 30, which helps reduce the power consumption of the display substrate on the premise of maintaining the brightness of the display substrate unchanged.

In this embodiment, the adhesion force between the second light adjustment layer 40 and the second sub-layer 32 is F3, the adhesion force between the second sub-layer 32 and the first sub-layer 31 is F4, an adhesion force between the first sub-layer 31and the light-emitting unit 21is F5, and F3≥F4>F5. With this arrangement, when the light-emitting unit 21 needs to be reworked, during the process of peeling off the first light adjustment layer 30 and the second light adjustment layer 40 from the light-emitting unit 21, since F3≥F4>F5, on the premise of ensuring that first sub-layer 31 and the light-emitting unit 21 are separated, avoiding the situation that the second light adjustment layer 40 and the second sub-layer 32 are separated or the second sub-layer 32 and first sub-layer 31 are separated while the first sub-layer 31 and the light-emitting unit 21 are still adhered together, the first light adjustment layer 30 and the second light adjustment layer 40 together can be smoothly peeled off from the light-emitting unit 21, which helps realize the rework of the light-emitting unit 21. In some embodiments, the size range of F3 and F4 may be 22N to 25N, and the size range of F5 may be 15N to 18N. For example, both F3 and F4 are 22N, 23N, 24N, or 25N, etc., and F5 may be 15N, 16N, 17N, or 18N, etc.

In this embodiment, the second sub-layer 32 is doped with auxiliary particles, and the auxiliary particles can increase the hardness of the second sub-layer 32 and reduce the creep value of the second sub-layer 32. The auxiliary particles are, for example, ultraviolet particles, and the hardness of the second sub-layer 32 increases after being irradiated with ultraviolet light. In some embodiments, when the second sub-layer 32 is not doped with auxiliary particles, its creep value is 1.7, and after the first sub-layer is doped with auxiliary particles, its creep value is 1.1. Alternatively, the light-transmitting material of the second sub-layer 32 is a thermosetting material, and the hardness of the second sub-layer 32 is increased by increasing its temperature.

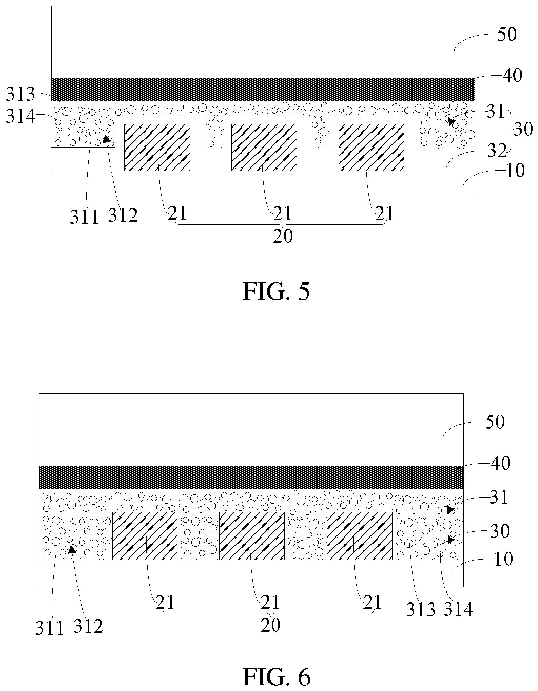

In an embodiment, as illustrated in FIG. 5, the first light adjustment layer 30 further includes the second sub-layer 32 located on a side of the first sub-layer 31 facing the substrate 10, the hardness of the first sub-layer 31 is greater than the hardness of the second sub-layer 32. Since the first sub-layer 31 is in contact with the second light adjustment layer 40 and the second sub-layer 32 is in contact with the light-emitting unit 21, by arranging that the hardness of the first sub-layer 31 is greater than the hardness of the second sub-layer 32, then the first sub-layer 31 can more effectively prevent the light-emitting unit 21 from squeezing the second light adjustment layer 40 and improve the thickness uniformity of the second light adjustment layer 40; when the light-emitting unit 21 needs to be reworked, the film layer located on a side of the light-emitting unit 21 away from the substrate 10 needs to be separated from the light-emitting unit 21, since the hardness of the second sub-layer 32 is smaller, that is, it is softer and easier to be separated from the light-emitting unit 21, which facilitates the rework of the light-emitting unit 21.

In this embodiment, the transmittance of the first sub-layer 31 is less than the transmittance of the second sub-layer 32. This arrangement can, on the premise of ensuring that the first light adjustment layer 30 and the light-emitting unit 21 are easily separated, reduce the impact on the transmittance of the first light adjustment layer 30, which helps reduce the power consumption of the display substrate on the premise of maintaining the brightness of the display substrate unchanged. In addition, since the hardness of the first sub-layer 31 is greater than the hardness of the second sub-layer 32, when the adjacent display substrates collide with each other during the splicing process of the display substrates, the first sub-layer 31 is not prone to edge loss; since the transmittance of the second sub-layer 32 is larger, even if the edge of the second sub-layer 32 misses during the splicing process of the display substrates, it has little impact on the display effect of the display substrate.

In this embodiment, the adhesion force between the second light adjustment layer and the first sub-layer is F6, the adhesion force between the first sub-layer and the second sub-layer is F7, the adhesion force between the second sub-layer and the light-emitting unit is F8, and F6≥F7>F8. With this arrangement, when the light-emitting unit 21 needs to be reworked, during the process of peeling off the first light adjustment layer 30 and the second light adjustment layer 40 from the light-emitting unit 21, since F6≥F7>F8, on the premise of ensuring that first sub-layer 31 and the light-emitting unit 21 are separated, avoiding the situation that the second light adjustment layer 40 and the second sub-layer 32 are separated or the second sub-layer 32 and first sub-layer 31 are separated while the first sub-layer 31 and the light-emitting unit 21 are still adhered together, the first light adjustment layer 30 and the second light adjustment layer 40 together can be smoothly peeled off from the light-emitting unit 21, which helps realize the rework of the light-emitting unit 21. In some embodiments, the size range of F6 and F7 may be 22N to 25N, and the size range of F8 may be 15N to 18N. For example, both F6 and F7 are 22N, 23N, 24N, or 25N, etc., and F8 may be 15N, 16N, 17N, or 18N, etc.

In this embodiment, the second sub-layer 31 is doped with auxiliary particles, and the auxiliary particles can increase the hardness of the second sub-layer 31 and reduce the creep value of the second sub-layer 31. The auxiliary particles are, for example, ultraviolet particles, and the hardness of the second sub-layer 31 increases after being irradiated with ultraviolet light. Alternatively, the light-transmitting material of the second sub-layer 31 is a thermosetting material, and the hardness of the second sub-layer 31 is increased by increasing its temperature.

In an embodiment, the surface of the first sub-layer 31 facing the substrate 10 is in direct contact with the light-emitting unit 21, the surface of the first sub-layer 31 away from the substrate 10 is in direct contact with the second light adjustment layer 40. That is, the first light adjustment layer 30 only includes the first sub-layer 31. With this arrangement, there is no other film layers between the light-emitting unit 21 and the first sub-layer 31, which can prevent the first sub-layer 31 from being affected by other film layers to cause uneven thickness of a part of the first sub-layer 31 located on top of the light-emitting unit 21, making the scattering effect of the first sub-layer 31 for each light-emitting unit 21 more consistent, which helps improve the display effect of the display substrate.

In this embodiment, the first sub-layer 31 is in direct contact with light-emitting unit 21, which means that there is no other film layers between the first sub-layer 31 and the light-emitting unit 21. In practice, as illustrated in FIG. 8, during the lamination process of the first intermediate structure and the second intermediate structure, some areas of the surface of the first sub-layer 31 facing the light-emitting unit 21 are not so smooth, which leads to there is a gap between first sub-layer 31 and the light-emitting unit 21.

In this embodiment, the adhesion force between the second light adjustment layer 40 and the first sub-layer 31 (i.e., the first light adjustment layer 30) is F1, the adhesion force between the first sub-layer 31 (i.e., the first light adjustment layer 30) and the light-emitting unit 21 is F2, and F1>F2. This can ensure that, when the light-emitting unit 21 needs to be reworked, the second light adjustment layer 40 and the first light adjustment layer 30 can be smoothly peeled off from the light-emitting unit 21. In some embodiments, the size range of F1 may be 22N to 25N, and the size range of F2 may be 15N to 18N. For example, F1 may be 22N, 23N, 24N, or 25N, etc., and F2 may be 15N, 16N, 17N, or 18N, etc.

In an embodiment, the transmittance range of first light adjustment layer 30 is 150 µm to 175 µm.This arrangement can ensure that the surface of the first light adjustment layer 30 away from the substrate 10 exceeds the surface of the light-emitting unit 21 away from the substrate 10, and at the same time can also avoid that the thickness of the first light adjustment layer 30 is so large as to increase the thickness of the display substrate. In some embodiments, the thickness of the first light adjustment layer 30 may be 150 µm, 155 µm, 160 µm, 165 µm, 170 µm, or 175 µm, etc.

In an embodiment, the thickness range of the second light adjustment layer is 25 µm to 50 µm.For example, the thickness of the second light adjustment layer 40 is 25 µm, 30 µm, 35 µm, 40 µm, 45 µm, or 50 µm, etc.

In an embodiment, the transmittance range of the first sub-layer is 25 % to 40 %. This can ensure the blackness of the display substrate in the non-display state, and also prevent the display substrate from increasing the power consumption of the display substrate due to low light utilization in the display state, which helps improve user experience.

In an embodiment, the second light adjustment layer 40 may include a light-transmitting material and black ions doped in the light-transmitting material, the black ions are, for example, carbon black. Or the second light adjustment layer 40 may include a light-transmitting material and a black dye material doped in the light-transmitting material.

In this embodiment, the second light adjustment sub-layer 40 is doped with auxiliary particles, and the auxiliary particles can increase the hardness of the second light adjustment sub-layer 40 and reduce the creep value of the second light adjustment sub-layer 40. The auxiliary particles are, for example, ultraviolet particles, and the hardness of the second light adjustment sub-layer 40 increases after being irradiated with ultraviolet light. Alternatively, the light-transmitting material of the second light adjustment sub-layer 40 is a thermosetting material, and the hardness of the second light adjustment sub-layer 40 is increased by increasing its temperature. In this manner, the hardness of the second light adjustment layer 40 is larger, and during the process of splicing multiple display substrates, it can avoid collision between adjacent display substrates to lead to the edge loss of the second light adjustment layer 40.

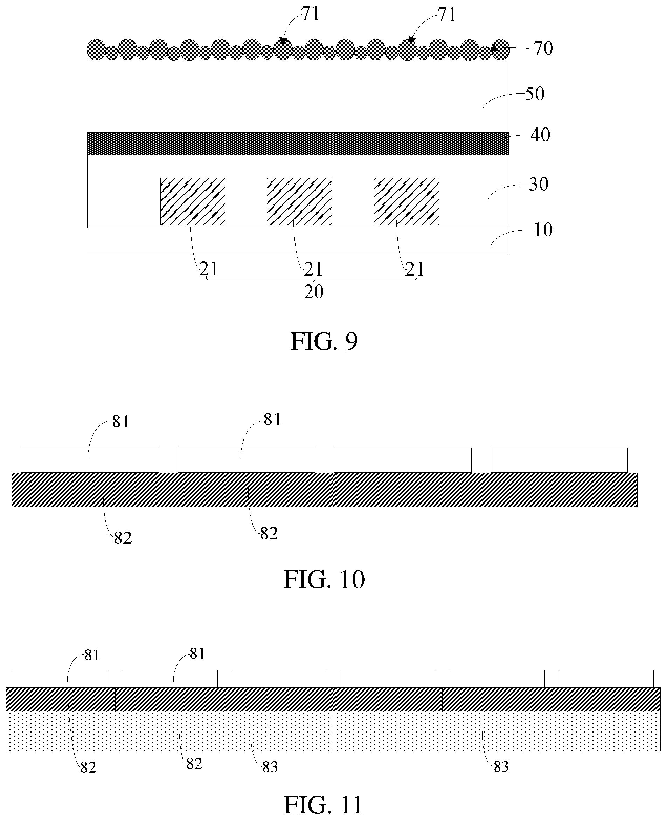

In an embodiment, as illustrated in FIG. 9, the display substrate further includes a functional film layer 70 located on a side of the protective layer 50 away from the substrate 10, and the functional film layer includes at least one of a hardened coating, an anti-fingerprint layer and an anti-glare layer. The hardened coating can increase the hardness of the display substrate surface and prevent scratches; the anti-fingerprint film layer can prevent fingerprint traces from being left on the display surface of the display substrate; and the anti-glare layer can reduce glare caused by reflection and other factors. In some embodiment, the display substrate further includes a functional film layer 70, which is reused as a hardened coating, an anti-fingerprint layer and an anti-glare layer. As illustrated in FIG. 9, a plurality of protruding structures 71 are formed on the surface of the functional film layer 70 away from the substrate 10.

In an embodiment, the light-transmitting material of the first light adjustment layer 30 and the second light adjustment layer 40 can both adopt acrylic colloid.

In an embodiment, the light-emitting substrate further includes a drive circuit layer, which is located between the light-emitting unit and the substrate. The drive circuit layer includes a plurality of pixel circuits and signal traces, and the pixel circuits and signal traces are electrically connected with the light-emitting unit.

Embodiments of the present disclosure further provide a spliced display module, as illustrated in FIG. 10 and FIG. 11, the spliced display module includes multiple display substrates 81 described in any one of the above embodiments.

In an embodiment, as illustrated in FIG. 10, the spliced display module further includes a plurality of first splicing frames 82, the display substrates 81 are fixed on the first splicing frames 82, where a display substrate 81 is fixed on a first splicing frame 82. The adjacent first splicing frames 82 are spliced together.

In an embodiment, the spliced display module further includes a plurality of first splicing frames 82 and a plurality of second splicing frames 83, where a plurality of first splicing frames 82 are fixed on a second splicing frame 83. The display substrates 81 are fixed on the first splicing frames 82, where a display substrate 81 is fixed on a first splicing frame 82. Among the plurality of first splicing frames 82 located on the same second splicing frame 83, the adjacent first splicing frames 82 are spliced together. The adjacent second splicing frames 83 are spliced together.

In an embodiment, at least two display modules in the spliced display module share the protective layer, the second light adjustment layer and the first light adjustment layer. For example, in the spliced display module, each display module fixed on the same first splicing frame 82 can share the protective layer, the second light adjustment layer and the first light adjustment layer.

Embodiments of the present disclosure further provide a display apparatus, which includes the display substrate described in any one of the above embodiments.

In an embodiment, the display apparatus further includes a housing, and the display substrate is embedded in the housing.

The display apparatus provided in the embodiments of the present disclosure may be any appropriate display apparatus, including but not limited to mobile phones, tablet computers, televisions, monitors, notebook computers, digital photo frames, navigators, e-books, and any other products or components with display functions.

Embodiments of the present disclosure further provide a display apparatus, which includes the spliced display module described in any one of the above embodiments.

In an embodiment, the display apparatus further includes a housing, and the spliced display module is embedded in the housing.

The display apparatus provided in the embodiments of the present disclosure may be any appropriate display apparatus, including but not limited to mobile phones, tablet computers, televisions, monitors, notebook computers, digital photo frames, navigators, e-books, and any other products or components with display functions.

It is to be noted that in the accompanying drawings, the dimensions of layers and regions may be exaggerated for clarity of illustration. It will be understood that when an element or a layer is referred to as being "above" or "on" another element or layer, it may be directly on the other element, or intervening layers may be present. In addition, it will be understood that when an element or a layer is referred to as being "under" or "below" another element or layer, it may be directly under the other element, or one or more intervening layers or elements may be present. In addition, it will also be understood that when a layer or an element is referred to as being "between" two layers or two elements, it may be the only layer between the two layers or two elements, or one or more intervening layers or elements may be present. Like reference numerals indicate like elements throughout.

Those skilled in the art will readily conceive other embodiments of the present disclosure upon consideration of the specification and practice of the various embodiments disclosed herein. The present disclosure is intended to cover any variation, use, or adaptive change of this disclosure. These variations, uses, or adaptive changes follow the general principles of this disclosure and include common general knowledge or common technical means in the art that are not disclosed in this disclosure. The specification and the embodiments are considered as merely exemplary, and the real scope and spirit of the present disclosure are pointed out in the following claims.

It should be understood that this disclosure is not limited to the precise structures described above and illustrated in the accompanying drawings, and various modifications and changes may be made without departing from the scope of the present disclosure. The scope of the present disclosure is limited only by the appended claims.

## Claims

1. A display substrate, comprising:
a substrate;
a light-emitting unit group on the substrate and comprising a plurality of light-emitting units;
a first light adjustment layer on the substrate; wherein a distance from a surface of the first light adjustment layer away from the substrate to the substrate is greater than a distance from a surface of one of the plurality of light-emitting units away from the substrate to the substrate; and
a second light adjustment layer on the first light adjustment layer and away from the substrate, wherein an orthographic projection of the second light adjustment layer on the substrate covers the substrate; and a transmittance of the first light adjustment layer is greater than a transmittance of the second light adjustment layer.

2. The display substrate according to claim 1, wherein the first light adjustment layer comprises a first sub-layer, and an orthographic projection of the first sub-layer on the substrate covers respective orthographic projections of each of the light-emitting units on the substrate; wherein the first sub-layer comprises a light-transmitting material and scattering particles dispersed in the light-transmitting material.

3. The display substrate according to claim 2, wherein the scattering particles comprise first particles and second particles, and a transmittance of the first particles is greater than a transmittance of the second particles.

4. The display substrate according to claim 3, wherein a mass percentage range of the first particles in the first sub-layer is from 10 % to 20 %, and a mass percentage range of the second particles in the first sub-layer is from 1 % to 5 %;
and/or, wherein a transmittance range of the first sub-layer is from 45 % to 70 %.

5. The display substrate according to claim 3, wherein a material of the first particles comprises silicon dioxide, polymethylmethacrylate, polystyrene, or any combination thereof, and a material of the second particles comprises titanium dioxide, zinc oxide, or both; wherein a particle size range of the first particles is from 400nm to 600nm, and a particle size range of the second particles is from 4 µm to 6 µm.

6. The display substrate according to claim 2, wherein the first light adjustment layer further comprises a second sub-layer on the first sub-layer and away from the substrate, wherein the first sub-layer covers each of the plurality of light-emitting units; and a hardness of the second sub-layer is greater than a hardness of the first sub-layer.

7. The display substrate according to claim 2, wherein the first light adjustment layer further comprises a second sub-layer on a side of the first sub-layer towards the substrate, and a hardness of the first sub-layer is greater than a hardness of the second sub-layer.

8. The display substrate according to claim 6 or 7, wherein a transmittance of the first sub-layer is less than a transmittance of the second sub-layer.

9. The display substrate according to claim 2, wherein a surface of the first sub-layer towards the substrate is in direct contact with the light-emitting unit, and a surface of the first sub-layer away from the substrate is in direct contact with the second light adjustment layer.

10. The display substrate according to claim 1, wherein an adhesion force between the second light adjustment layer and the first light adjustment layer is F1, an adhesion force between the first light adjustment layer and the light-emitting unit is F2, and F1>F2.

11. The display substrate according to claim 1, wherein the first light adjustment layer comprises a first sub-layer and a second sub-layer on the first sub-layer and away from the substrate; wherein an adhesion force between the second light adjustment layer and the second sub-layer is F3, an adhesion force between the second sub-layer and the first sub-layer is F4, an adhesion force between the first sub-layer and the light-emitting unit is F5, and F3≥F4>F5; or,
the first light adjustment layer comprises a first sub-layer and a second sub-layer on a side of the first sub-layer towards the substrate; an adhesion force between the second light adjustment layer and the first sub-layer is F6, an adhesion force between the first sub-layer and the second sub-layer is F7, an adhesion force between the second sub-layer and the light-emitting unit is F8, and F6≥F7>F8.

12. The display substrate according to claim 1, wherein a thickness range of the second light adjustment layer is from 25 µm to 50 µm; and/or, a transmittance range of the second light adjustment layer is from 25 % to 40 %.

13. The display substrate according to claim 1, further comprising a protective layer on the second light adjustment layer and away from the substrate.

14. The display substrate according to claim 13, wherein an adhesion force between the protective layer and the second light adjustment layer is F9, an adhesion force between the second light adjustment layer and the first light adjustment layer is F1, and F9≥F1.

15. The display substrate according to claim 13, further comprising a functional film layer on the protective layer and away from the substrate, and wherein the functional film layer comprises a hardened coating, an anti-fingerprint layer, an anti-glare layer, or any combination thereof.

16. A spliced display module, comprising a plurality of splicing units, and each of the plurality of splicing units comprises the display substrate according to any one of claims 1 to 15.

17. A display apparatus, comprising the display substrate according to any one of claims 1 to 15, or, the display apparatus comprises the spliced display module according to claim 16.
